# EUROPEAN PATENT SPECIFICATION

(11) **EP 3 361 514 B1**
(45) Date of publication and mention of the grant of the patent: **01.09.2021**
(21) Application number: 17173768.7
(22) Date of filing: 31.05.2017
(51) Int. Cl.: H01L 31/054, H01L 31/0236, H01L 31/048

(54) **PANE FOR A PV-MODULE AND PV-MODULE**
SCHEIBE FÜR EIN PV-MODUL UND PV-MODUL
PANNEAU POUR MODULE PV ET MODULE PV

(30) Priority: 13.02.2017 EP 17155918
(43) Date of publication of application: 15.08.2018
(73) Proprietor: Kreft, Norbert, 77971 Kippenheim (DE)
(72) Inventor: Kreft, Norbert, 77971 Kippenheim (DE)
(74) Representative: Lohr, Jöstingmeier & Partner

(56) References cited:
- DE-A1-102012 210 446
- FR-A1- 3 021 800
- US-A- 5 725 006
- US-A1- 2013 170 192

## Description

### Field of the invention

The invention relates to a method of manufacturing a front pane for a photovoltaic-module, the pane and to a photovoltaic-module comprising the pane.

### Description of the related art

Photovoltaic-modules convert light into electrical energy. Photovoltaic modules generally, are essentially a number (one or more) of photodiodes being connected in series (and/or parallel) to provide a power source. The photodiodes are protected against mechanical and chemical stress by a rear substrate and a transparent front cover. Very briefly summarizing, photons generate electron hole pairs being separated by a p-n junction of the photodiode(s). The potential energy of the charge separation can be made available by connecting the two types of semiconductors of the photodiode with an electric load to thereby form an electrical circuit. More detailed introductions can be found in textbooks like e.g. Sakurai, Modern Quantum Mechanics, p. 339ff (Addison Wesley, 1994), Tippler Physik, Chapter 35.2 (Spektrum Akad. Verlag Heidelberg, 2000) or Hering, Martin, Stohrer, Physik für Ingenieure, Chap. 9.4.2.3 (VDI Verlag Düsseldorf, 1989) to name only a few.

Photovoltaic (PV) modules typically show the color of the respective semiconductor, being visible through the front cover of the PV-module. For example Si-base modules appear blue and CdTe-modules have a black appearance. In some applications, these colors are not accepted for aesthetic reasons. There have been attempts to provide PV-modules showing other colors. For example, in WO 2014/045144 A1 an interference filter is suggested that provides an orange-colored glazing. The interference filter reflects only a narrow spectral band and is transparent for the remaining wavelengths.

Another attempt to influence the optical appearance of PV-modules is to deposit an interferometric mask covering the front electrodes to thereby reduce reflections of the front electrodes as suggested in EP 2058 863 A2. Further, the mask may be designed to show the same color as the semiconductor material next to it. Accordingly, the front electrodes do not affect the visual appearance of the PV-module.

DE 10 2012 210 446 A1, US 2013/0170192 A1 and US 5,725,006 A each disclose a PV-module having a front pane and a plurality of photovoltaic elements arranged next to the front pane. FR 3 021 800 A1 discloses a display with an integrated solar cell supporting a plurality of display pixels.

### Summary of the invention

The problem to be solved by the invention is to enable manufacturing of colored PV-modules and to provide the means for manufacturing colored PV-modules.

Solutions of the problem are described in the independent claims. The dependent claims relate to further improvements of the invention.

A PV-module comprises a front cover of a transparent material, typically of glass, i.e. a glass pane (for short 'pane'). Principally, the pane can as well be of any transparent material, but herein we assume that the pane is of glass. As usual, the pane has a front surface (as well referred to as front side) and a rear surface (as well referred to as front side) facing away from front surface. When mounted in a PV-module, the front surface of the pane faces towards the sun or another light-source and the rear surface faces towards the respective PV-module's photodiodes. As usual the pane has narrow sides (at least one) connecting the front and rear surfaces. Mathematically speaking, the panes are thus preferably (flat) cuboids, but other forms like (flat) cylinders, or (flat) prisms can be used as well. '(Flat)' means here that the front and rear surface are preferably at least essentially parallel and that their surface is large compared to the surface of the connecting narrow side(s). Beyond, the front and rear surfaces are preferably at least approximately congruent.

When manufacturing a PV-module one first has to provide the front pane. Subsequently a transparent conducting layer (TCL) is applied to the rear surface of the front pane. For example a TCO-layer may be used as transparent conducting layer, wherein the abbreviation TCO stands for **T**ransparent **C**onductive **O**xide. These TCO-layers may comprise e.g. Zink oxide (ZnO), Tin oxide (SnO₂), Indium oxide (In₂O₂), and/or Cadmium Stanate (CdSnO₄) to name only a few. They are known in the art and a large number of publications are available. But other materials can be used as TCL as well, like e.g. conductive polymers, metal grids, carbon nanotubes, ultra-thin metal films and essentially any material that is chemically compatible with the pane as well as with the material of the photoelectric cell. In addition the material should be conductive and transparent in the relevant wavelengths.

Below the transparent conducting layer are semiconductor layers providing at least one photoelectric cell, as well referred to as photovoltaic cell or photo diode. Typical photodiode semiconductor layers comprise a Cadmium-Telluride (CdTe) layer and a Cadmium arsenide (CdAs) layer, doped Silicon layers, Copper Indium Diselenid layers (CIGSs), Gallium arsenide (GaAs) or the like. On these layers a further TCL may be deposited, e.g. again a TCO-layer. A reflective layer may follow as well as a back substrate, e.g. a second glass pane. The pane and the rear substrate may be connected by a lamination process or the like to safely enclose the photodiode and the connection layers. The contact layers may be connected to connectors being typically mounted to the rear substrate or to a narrow side of the laminate. The compound being enclosed by the front pane and the rear substrate (including the front pane, the rear substrate and the connectors) is commonly referred to as PV-module.

The sequence of manufacturing can of course be reversed. Thus, the process may as well start with providing a rear substrate and by deposition of the respective layers forming the photodiode on the rear substrate (in the reverse order as indicated above) and (essentially) finalizing the PV-module by lamination of the front pane to the rear substrate and the layer being previously provided to the rear substrate.

The invention enables to provide PV-modules in almost any color with only a very low loss in efficiency by providing a colored front pane having on the one hand a remarkable color intensity and on the other hand a remarkable transmissivity. In addition manufacturing costs are low. The pane can be used as colored front cover for essentially any type of PV-module.

The method of providing a colored front pane for a PV-module, comprises at least two main steps:
(i) providing a transparent pane having at least one front side and a rear side, wherein the front side comprises recesses with protrusions in between,
(ii) at least partially filling the recesses with a colored coating, wherein the protrusions remain uncoated.

For example, step (i) may comprise abrasive blasting a plane pane's front side (as commercially available) to thereby form consecutive recesses with protrusions in between. In other words, in between of two neighbored recesses is at least one protrusion, which separates the recesses. The technique of abrasive blasting provides an almost arbitrary spatial distribution of recesses with the respective protrusion(s) in between and thus provides a pane for PV-module homogenous color intensity and homogenous transparency. Only to avoid ambiguities, the term abrasive blasting of the front surface is considered to refer to the technique of propelling an abrasive material against the pane's front surface to thereby roughen the previously smooth glass surface. The abrasive material is commonly referred to a as shot or grit and by selecting the grit, one may define the size of the recesses.

Alternatively or in addition, step (i) may comprise laser ablation to thereby form consecutive recesses with protrusions in between. Laser ablation is considered as the process of removing material from the pane's front surface by irradiating it with a laser beam. The surface may be subjected, e.g. be scanned with a laser's beam to evaporate or sublimate small portions of the pane which subjecting thereby provides recesses in the pane in between of protrusions being formed by the pane's body (i.e. its transparent material). The recesses may have the form of grooves. For example the recesses may be elongate grooves, one next to the other with at least one protrusion in between. Laser ablation as well enables to form only a single groove with a very small width. The (single) groove may however span over a large area of the front surface. For example, the groove may form a spiral or a similar pattern on the front surface. For the purpose of this patent, such patterns are considered to form a number of consecutive grooves as they appear as such in cross sectional view.

As well, step (i) may comprise etching the front surface of a pane to thereby form the recesses with protrusions in between. There exist other techniques enabling structuring the surface of pane (e.g. scraping), these can be used as well.

Preferably, the recesses have a depth between 50 µm to 750 µm, even more preferred of 100 µm to 500 µm and even more preferred between 200 µm to 500 µm, wherein the depth is measured relative to the mean height of the protrusions.

After providing the recesses, step (ii) may be started. Step (ii) comprises partially filling at least some of the recesses of the pane by a colorant.

In particular in case of a glass pane the colorant can be (preferably) a glass ceramic or a ceramic colorant. Suited colorants are commercially available and known in the art (see e.g. WO 2001/30714A; WO 2006/028286 A; WO 2006/124088A; US 5,304,516; US 5,674,789, to name only a few). The teaching of these publications may be used to select a particular colorant, often as well referred to as enamel.

It is noted that other colorants may be used as well, e.g. colorants (pigments) as commercially available e.g. from Fa. Merck and my other suppliers. These pigments may be dispersed in a fluid, like e.g. water or another suited fluid. The pigments may thus be applied to the front surface of the front pane by applying the respective dispersion to the front surface. When applying dispersion to the front surface the pigments accumulate in the recesses. This may be enhanced by reducing the surface energy of the dispersion. After the dispersion has been applied, the front pane is preferably dried. If required, the colorant(s) may be cured.

In particular, if colorants different from glass ceramic or ceramic colorants are used, it is preferred to apply a transparent layer, e.g. a layer of Silicon-Dioxide (SiO₂) on top of the colorant layer (and the protrusions). The SiO₂ layer may be applied, e.g. by sputtering.

In a preferred embodiment the colorant has infra-red (IR) reflective properties. These reflective properties enhance the efficiency of the PV-module.

Partially filling the recesses does not mean to fill only a few recesses, but instead to fill preferably essentially all recesses only partially. Filling essentially all recesses means that 75% or more of the recesses are filled, preferably 95% and even more preferred 99% of the recesses are filled. The percentage of the filled recesses has an impact on color appearance: a high filling rate yields saturated colors, whereas a low filling rate yields less saturation. But if some are omitted, this shall not be excluded. Thus, partially filling means that the filled recesses are filled up to a height that is smaller than the depth of the respective recess at the end of the filling step. In other words, partially filling implies that the side walls of the recesses extend over the top surface of the colorant.

The step of partially filling may for example comprise: deposition of the colorant to the front surface of the pane, thereby covering the recesses and the protrusions in between. Subsequently, the colorant may be partially removed, thereby freeing the tops of the protrusions from the colorant, only. The bottoms of the recesses remain covered by the colorant. In other words, the tops of the protrusions in between of the recesses are freed from the colorant by simply removing the colorant from them, e.g. by etching, laser ablation, grinding or the like. Accordingly, partially filled recesses are formed.

In particular in case the colorant is a glass-ceramic colorant it is preferably cured after partially filling the recesses or during the filling process. To this end at least the front side of the pane may be subjected to heat or ultraviolet radiation to thereby cure and thus fix the colorant in the recesses.

In a preferred embodiment, said curing comprises vitrification of the colorant. For example the colorant may comprise an enamel as explained below, which may comprise ceramic particles. The enamel may be applied to the surface of the pane and may subsequently be subjected to vitrification by heating colorant and the at least the panes front surface. Applying the colorant is intended to express here that the colorant is at least applied to the recesses, thereby covering (coating) at least the recesses' bottoms by the colorant. Suited particles are commercially available e.g. from Ferro GmbH, Frankfurt, Germany. The vitrified colorants are embedded in the pane and thus protected against wear by the pane's material, e.g. glass.

Particularly preferred, the tops of the protrusions are flattened. This flattening may be obtained by mechanical means like grinding, but part particularly preferred the flattening is obtained by heating (at least) the tops. The material of the pane in turn softens and becomes smooth or at least essentially flat. This flattening step may be performed at the same time as the curing step, e.g. during vitrification of the colorant. These two steps, i.e. flattening and curing, may take place at the same time in the same heating process, thereby rendering the manufacturing process more efficient. As will be explained below in more detail with respect to the figures, the flattened tops enhance the transmissivity of the pane and thus the efficiency of the later PV-module.

Prior to partially filling the recesses with the colorant, a reflective layer may be deposited in the recesses. Thus, after partially filling the recesses with the colorant, the reflective layer is in between of the pane's transparent material and the colorant. This reflective layer has two advantages: the colors appear brighter and in addition the efficiency of the PV-module is enhanced, as the reflective layer reflects backscattered light towards the rear surface of the pane and thus towards the photodiode as explained in more detail with respect to the Figures.

The reflective layer can be provided by or comprise a metal layer, e.g. of silver or aluminum another suited metal as used e.g. for mirrors.

To avoid ambiguities, a reflective layer is a layer that shows reflective properties for photons having a wavelength (and thus a corresponding energy), that enables charge separation in the photodiode. In detail, this would require that the energy of the photon is bigger or equal to the band gap of the photodiode. For most commonly used photodiodes one may shorten this in saying that the reflective layer is reflective (reflectivity of 75% or more, preferably 80% or more, even more preferred 90% or more, particularly preferred 95% or more) for visible wavelengths. Thus, the reflective layer is reflective at least for visible light. In other words, the reflective surface is a mirror.

After completing step (ii) a TCL may be deposited on the rear side of the pane, i.e. on the surface of the pane facing away from the surface with the partially filled recesses. Subsequently photo-electric cell(s), a rear contact and a rear substrate can be added as usual to the front pane. But alternatively the steps (i) and (ii) may performed after deposition of the photodiode or in the photodiode's manufacturing process.

The recesses preferably have a bottom and one or more sidewalls. The distance from the bottom to the tops of the protrusions defines the protrusions' depth. The recesses are preferably tapered as this enhances the efficiency of the later PV-module: A tapered recess is a recess having width or diameter at its bottom which is smaller than the corresponding dimension at its upper edge. The side wall(s) are thus inclined relative to the normal direction of the pane (and thus after assembly of the PV-module towards the photodiode(s). As the side wall(s) define(s) a material transition from the pane's transparent material to the colorant and thus an interface surface, they are reflective (at least to a certain extent, provided the refractive indices of the two materials have been selected appropriately). Due to their inclination they reflect light entering the pane via the transparent tops of the protrusions at an acute or oblique angle towards the pane's rear surface, i.e. towards the photodiode(s). In other words, light entering the pane not in parallel to the pane's intended optical axis (which is the front surface's normal direction prior to forming the recesses or simply assuming there are no recesses) is directed by the interface surface towards the rear surface.

The method thus provides a front pane for a PV-module, wherein the pane comprises a transparent material with a front and a rear side. The front and the rear sides are connected by at least one narrow side. For example, a pane with a circular contour has only a single narrow side and a pane with a rectangular contour has four narrow sides. Other contours are possible as well, but currently rectangular contoured panes are mostly used for PV-modules.

The transparent material of the pane has recesses. The recesses are separated by protrusions and are partially filled with a colorant as explained. The corresponding pane has the color appearance of the colorant, but is still transmissive for light.

The partially filled recesses are preferably tapered, to thereby enhance the light being emitted trough the rear surface if light is directed to the front surface. Tapered may include, but is not limited to a conical or even more preferred to a frustro-conical (truncated) shape. Generally tapered means that the diameter (or width, depending on the contour) at the recesses bottom is smaller than the respective dimension measured at its open end, i.e. at the upper edge.

Preferably, the recesses have a depth of 100 µm to 600 µm, even more preferred of 200 µm to 400 µm, wherein the depth is measured relative to the mean height d of the protrusions. The color layer in the partially filled recesses preferably has a thickness between 50 µm to 500 µm, and even more preferred between 100 µm to 300 µm. This combination provides an astonishing color saturation and at the same time a remarkable transmissivity for light.

The mean maximum thickness of the colorant layer in the recesses is in between of 1/10 and 9/10 (even more preferred between 3/10 and 7/10) of the mean height d of the protrusions relative to the bottoms of the recesses. The maximum thickness of a colorant layer in a recess is the distance from the surface of the colorant and the bottom of the respective recess.

According to the invention, the colorant has a lower refraction index than the transparent material. This enhances total reflection at the interface surface(s) between the two materials and thus the amount of light that is directed through the pane. The efficiency of the PV-module with the respective pane is thus enhanced.

In addition a transmissive cover layer may cover the protrusions and the colorant, wherein the transmissive cover layer has a lower index of refraction than the colorant and preferably as well as the body material. This choice as well enhances the efficiency of the PV-module. In addition, the cover layer is preferably flat, i.e. it fills at least the recesses thereby providing an essentially flat top surface of the pane. This flat surface has the advantage, that dust or other particles that are transported e.g. by the wind onto a PV-module comprising the pane are washed e.g. off by rain. Further, the top surface dries faster, i.e. the risk of incrustations is lowered and the (risk of) growth of biofilms is reduced. In other words the long time transmissivity is enhanced.

If an interference filter is provided to the rear surface of the front pane, the color impression to a viewer may be further enhanced, but on the other hand the transmissivity of the front pane is further deceased (and thus the efficiency of the corresponding PV-module) and the cost for applying the interference filter raises the costs of the front pane. The interference filter may e.g. be a filter as explained in WO 2014/045144 A1.

The invention enables to provide a PV-module comprising the above explained front pane, a rear substrate and at least one photoelectrical cell in between of the front pane and the rear substrate.

### Description of Drawings

In the following the invention will be described by way of example, without limitation of the general inventive concept, on examples of embodiment with reference to the drawings.
Figure 1 shows a pane.
Figure 2 shows detail D of Figure 1.
Figure 3 shows detail D of Figure 2 after a coating step.
Figure 4 shows detail D of Figure 2 after a partially filling step.
Figure 5 shows detail D of Fig. 4 after a curing step.
Figure 6 shows detail D of Fig. 5 after an optional coating step.
Figure 7 shows a cross sectional sketch of another front pane 10.
Figure 8 shows a detail of a further pane.
Figure 9 shows a PV-module with a front pane.

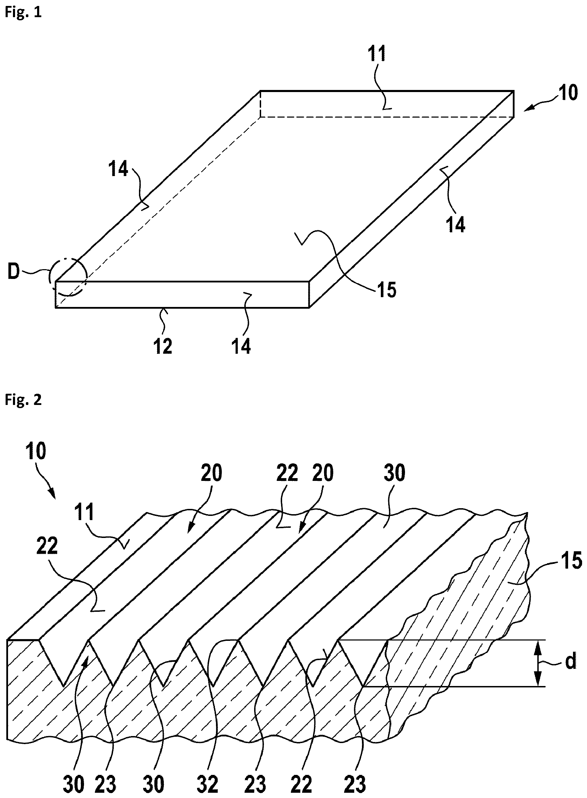

FIG. 1 shows a pane 10 comprising a body 15 of a transparent material. The pane has a front surface 11, a rear surface 12 and narrow sides 14. As can be seen (e.g.) in FIG. 2, depicting the detail D of FIG. 1, the pane has recesses 20. In between of two neighbored recesses 20 is a protrusion 30. The upper part of the protrusions 30 are indicated by '32' and referred to as top(s) 32 of the protrusions 30. The depth of the protrusions 30 is indicated by d. The dimension of d is preferably in between of 100 µm to 600 µm, even more preferred in between of 200 µm to 400 µm. In this example, the protrusions' bottoms 23 form lines, i.e. the bottom is edge where the side walls 22 of the protrusions 20 merge. But as explained below, the bottoms 23 may as well be bottom surfaces instead of bottom lines. Providing such a pane 10, would e.g. correspond to step (i) as explained above.

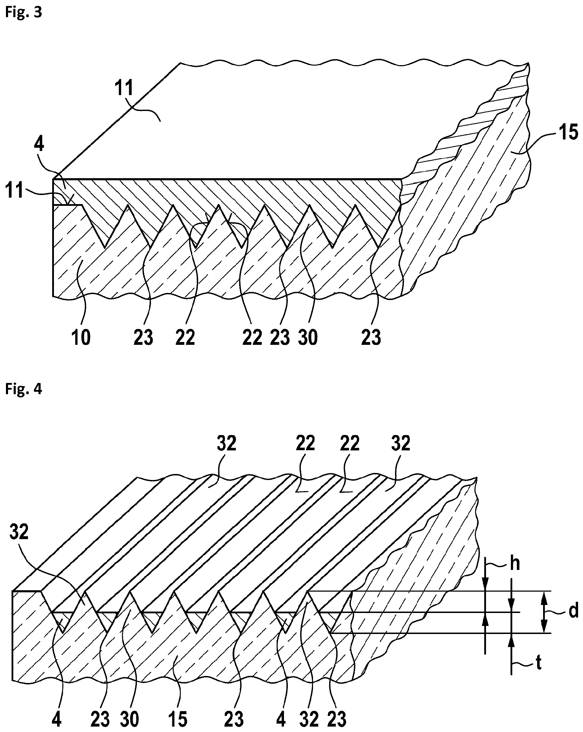

In the depicted the example, the recesses 20 are elongate grooves. Recesses 20 like these can be manufactured, e.g. by laser ablation or etching using masks. In the subsequent manufacturing step, the recesses 20 are partially filled with a colorant 4. One possibility for partially filling the recesses 20 with a colorant 4 is explained with respect to FIGs. 3 and 4. As can be seen in FIG. 3, a colorant layer 4 is deposited on the front facing side of the pane 10. The colorant 4 fills the recesses 20 completely and covers the protrusions 30. Subsequently, the colorant 4 is partially removed until the tops 32, i.e. the upper regions 32 of the protrusions 30 are freed as depicted in FIG. 4; the bottoms 23 of the recesses 20 are still covered by the colorant. The remaining thickness t of the colorant layer is preferably about half of the depth d (±25%). The portion of the protrusions 30 which extends above the colorant 4 is referred to a top 32.

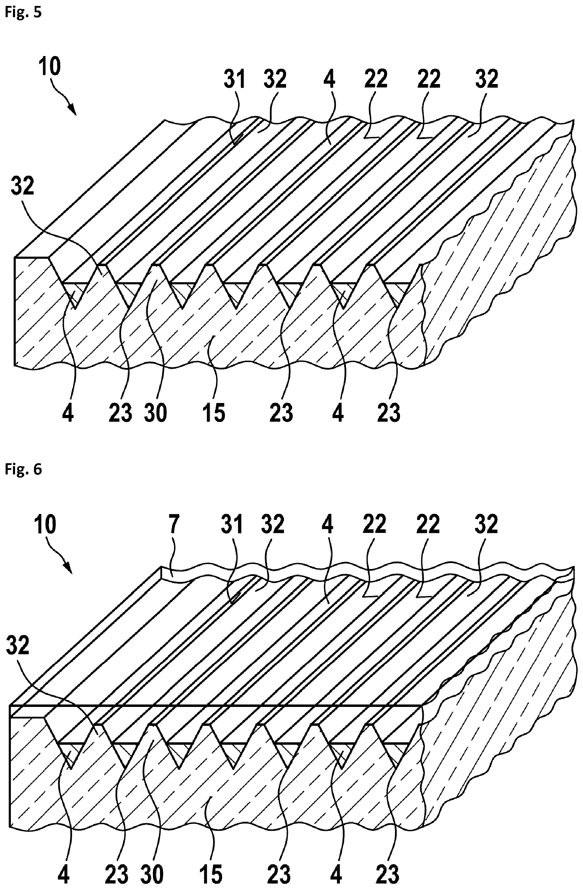

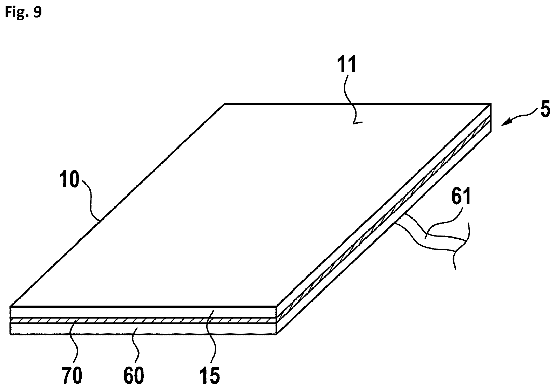

Subsequently, the remaining colorant 4 can be cured, e.g. by heating. When heating the colorant 4, one preferably heats as well the material of the pane and the tops 32 soften. By this softening, the tops 32 'melt' and change their shape as indicated in FIG. 5. The top's crest transforms into a flattened ridges. The tops 32 of the protrusions 30 thus have now an essentially flat surface 31. The prepared pane 10 can be used to manufacture a PV-module 5 (see FIG. 9), where the front surface 11 of the pane 10 defines the front side of the PV-module (5), i.e. the light exposed surface of the PV-module.

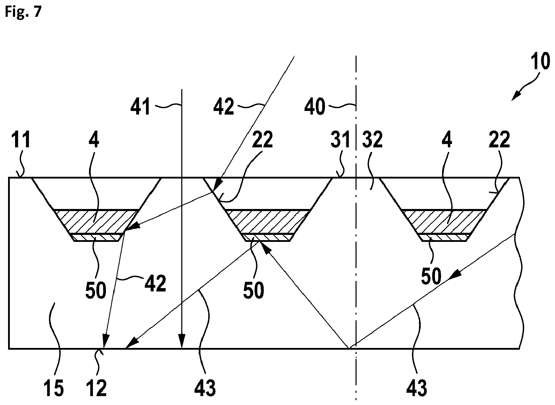

In a preferred embodiment, the pane as shown in Fig. 5 can be coated with a transparent coating 7, i.e. a transparent layer like e.g. a glass layer (see Fig. 6). The transparent coating preferably has a lower index of refraction than the material of the body 15, to thereby avoid total reflection at the interface between body 15 and the layer 7. The transparent coating can be applied by sputtering of SiO₂ or any other suited method. The layer protects the colorant and the structure of the body 15, i.e. in particular the protrusions 30 from wear. Further, the transparent layer 7 preferably provides an at least essentially plane surface. This provides the effect that dust of other particles cannot accumulate in the recesses 20. The dust would deteriorate the transmissivity of the pane and thus the efficiency of a PV-module with the pane 10. Water (e.g. after rain) pours of better and sublimates due to the lack of recesses. This as well enhances the efficiency. The layer 7 was omitted in the embodiments of FIGs. 7 to 9, but of course be applied as well to the panes 10 being depicted in these Figures.

FIG. 7 shows a cross sectional sketch of another pane 10. The pane 10 can be manufactured using the same method as the pane 10 of FIG. 5. Only for illustrative purposes, the pane is drawn extremely thin, because in practice the thickness of the pane (typically 3 to 7mm) is large against the depth of the recesses 20. As can be seen, the pane 10 as well has recesses 20 with protrusions 30 in between. But different from the recesses 20 in FIG. 5, the recesses 20 in FIG. 7 have a bottom surface 23 (instead of a line). The bottom 23 is preferably flat and parallel to the front and rear surfaces 11, 12. Beyond, the description of FIGs. 1 to 5 can be read as well on FIG. 6.

In FIG. 7, three cases of light incidence have been depicted for illustrative purposes (to this end the hatching of the body 15 has been omitted):
(i) A first ray 41 of light enters the front surface 31 of the protrusion 30 perpendicular to the front surface 31 (and thus parallel with the pane's optical axis 40) and exits the rear surface 12 of the pane. This ray would thus likely interact with photodiode of PV-module 5. The photodiode can be positioned below the rear surface 12 of the pane.
(ii) A second ray 42 of incident light enters the pane 10 via the non-colorant coated section of a protrusion's side wall 22. This second ray 42 is totally reflected by the interface surface between the coating 4 and the transparent material (represented by body 15) of the pane 10 and leaves the pane 10 via its rear surface. This second kind of ray 42 would thus as well interact with a photodiode being positioned at the rear side of the pane 10.
(iii) A third ray 43 enters the pane 10 and is back scattered from the rear surface 12. The back scattered part is reflected by the interface surface being provided by the side wall's 10 surface towards the rear surface 12 again, where it exits the pane 10 towards a photodiode.

FIG. 7 shows an optional reflective layer 50 in between of the bottom 23 and the colorant 4. This reflective layer of thickness t' (e.g. a metal layer) may as well be present in the other embodiments (Figs. 1 to 6) it has been omitted for simplicity, only. The reflective layer may as well extend between the side walls 22 and the colorant 4. The reflective layer 50 has two beneficial effects: first, the color of the pane 10 appears brighter and second, the reflection of previously back scattered light towards the rear surface 12 is enhanced. In presence of the reflective layer 50, the above mentioned interface surface is of course the interface surface between the reflective layer 50 and the transparent material of the body 15.

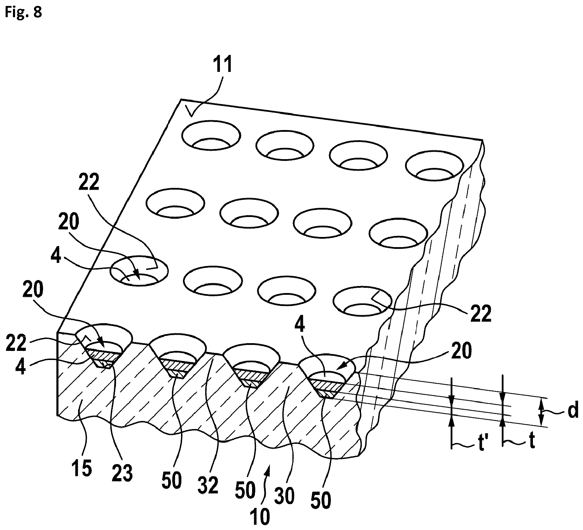

FIG. 8 shows another embodiment: This embodiment is very similar to the embodiment of FIG. 7 and the description of FIG. 7 can be read as well on FIG. 8 except that the recesses 20 are not elongate but partially filled holes 20 with a bottom 23.

FIG. 9 shows a PV-module 5 having a pane 10 and a rear substrate 60 with a photodiode 70 in between. The power being provided by the photodiode can be provided by a connector cable 61 to an energy consumer.

### List of reference numerals

- 4: colorant
- 5: PV-module
- 7: transparent layer / e. g. glass layer
- 10: pane
- 11: front surface /front side
- 12: rear surface
- 14: narrow sides
- 15: body
- 20: recess
- 22: side wall of a protrusion 30 and at the same time of the respective recess 20
- 23: bottom
- 30: protrusion
- 31: front surface
- 32: the upper regions/portions of the protrusions 30 ('tops 32' for short)
- 40: optical axis
- 41: first ray
- 42: second ray
- 43: third ray
- 50: reflective layer
- 60: rear substrate
- 61: connector cable
- d: depth or recess 20
- t: thickness of colorant 4
- h: height of tops 32
- D: detail

## Claims

1. A method of manufacturing a front pane (10) for a PV-module (5), comprising at least the steps of:
(i) providing a transparent pane (10) of a transparent material, the pane having at least a front side (11), wherein the front side (11) comprises recesses (20) with protrusions (30) in between, wherein each recess has a bottom (23)
(ii) at least partially filling the recesses (20) with a layer of a colorant (4), wherein an upper region (32) of the protrusions remains uncoated and extends above the colorant (4),
**characterized in that** the colorant has a lower refraction index than that of the transparent material

2. The method of claim 1, **characterized in that**
step (i) comprises sand blasting a pane's front side (11) and or laser ablation to thereby form recesses (20) with the protrusions (30) in between.

3. The method of one of claims 1 or 2, **characterized in that** step (i) comprises etching the front surface (11) of a pane (10) to thereby form the recesses (20) with protrusions (30) in between.

4. The method of one of claims 1 to 3, **characterized in that** step (ii) comprises: depositing the colorant (4) on the pane's front surface (11) and subsequently removing the colorant from the upper regions of the protrusions (30) to thereby obtain recesses (20) in between of the protrusions (30) that are partially filled with the colorant.

5. The method of claim 4, **characterized in that**
the colorant is cured after removal of the colorant from the upper regions of the protrusions (30).

6. The method of claim 5, **characterized in that** said curing comprises heating the front surface 11 of the pane 10 thereby melting the upper portion (32) of the protrusions (30).

7. The method of one of claims 1 to 6, **characterized in that** an interference filter is deposited after completion of step (ii) and/or on a rear side (12) of the front pane (10), which rear side (12) faces in the opposite direction as the front side (11).

8. A front pane (10) for a PV-module (5), wherein the pane (10) comprises a body (15) of a transparent material with a front side (11) and a rear side (12), wherein
- the transparent body (15) has recesses (20) in its front side (11), said recesses being separated by protrusions (30) of the transparent body,
- the recesses are at least partially filled with a colorant (4), wherein an upper region (32) of the protrusions remains uncoated and extends above the colorant (4),
**characterized in that** the colorant has a lower refraction index than the transparent material.

9. The front pane (10) of claim 8,
**characterized in that** the recesses (20) have depth of 50 µm to 750 µm, wherein the depth is measured relative to the mean height of the protrusions (30).

10. The front pane (10) of claim 8 or 9,
**characterized in that**,
the mean maximum thickness of the colorant layer (4) in the recesses (20) is in between of 1/10 and 9/10 of the mean height of the protrusions (30) relative to the bottoms of the recesses (20).

11. The front pane (10) of one of claims 8 to 10,
**characterized in that**
a transmissive cover layer covers the protrusions and the colorant, wherein the transmissive cover layer has a lower refraction index than the colorant (4).

12. A PV-module (5) comprising a front pane (10) with a front surface (11) and rear surface (12), a rear substrate (60) and at least one photodiode 70 in between of the rear surface (12) of the front pane (10) and the rear substrate (60), **characterized in that**
the front pane (10) is a front pane (10) of one of claims 8 to 11.

## Patentansprüche

1. Ein Verfahren zur Herstellung einer Frontscheibe (10) für ein PV-Modul (5), aufweisend zumindest die Schritte:
(i) Bereitstellen einer transparenten Scheibe (10) aus einem transparenten Material, wobei die Scheibe mindestens einer Frontseite (11) hat, wobei die Frontseite (11) Aussparungen (20) mit dazwischenliegenden Vorsprüngen (30) aufweist, wobei jede Aussparung einen Boden (23) hat
(ii) zumindest teilweises Füllen der Aussparungen (20) mit einer Schicht eines Farbstoffs (4), wobei ein oberer Bereich (32) der Vorsprünge unbeschichtet bleibt und sich über den Farbstoff (4) erstreckt,
**dadurch gekennzeichnet, dass**
der Farbstoff einen niedrigeren Brechungsindex als das transparente Material hat.

2. Das Verfahren nach Anspruch 1, **dadurch gekennzeichnet, dass** Schritt (i) Sandstrahlen einer Scheiben-Frontseite (11) und/oder Laserablation aufweist, um dadurch Aussparungen (20) mit den dazwischenliegenden Vorsprüngen (30) zu bilden.

3. Das Verfahren nach einem der Ansprüche 1 oder 2, **dadurch gekennzeichnet, dass**
Schritt (i) Ätzen der Frontfläche (11) einer Scheibe (10) aufweist, um dadurch die Aussparungen (20) mit dazwischenliegenden Vorsprüngen (30) zu bilden.

4. Das Verfahren nach einem der Ansprüche 1 bis 3, **dadurch gekennzeichnet, dass**
Schritt (ii) aufweist: Abscheiden des Farbstoffs (4) auf der Scheiben- Frontfläche (11) und anschließendes Entfernen des Farbstoffs von den oberen Bereichen der Vorsprünge (30), um dadurch Aussparungen (20) zwischen den Vorsprüngen (30) erhalten, die teilweise mit dem Farbstoff gefüllt sind.

5. Das Verfahren nach Anspruch 4, **dadurch gekennzeichnet, dass** der Farbstoff nach dem Entfernen des Farbstoffs von den oberen Bereichen der Vorsprünge (30) gehärtet wird.

6. Das Verfahren nach Anspruch 5, **dadurch gekennzeichnet, dass** das Aushärten ein Erhitzen der Frontfläche (11) der Scheibe (10) aufweist, wodurch der obere Abschnitt (32) der Vorsprünge (30) geschmolzen wird.

7. Das Verfahren nach einem der Ansprüche 1 bis 6, **dadurch gekennzeichnet, dass**
nach Abschluss des Schrittes (ii) und/oder auf einer Rückseite (12) der Frontscheibe (10) ein Interferenzfilter aufgebracht wird, wobei die Rückseite (12) in entgegengesetzte Richtung wie die Frontseite (11) weist.

8. Eine Frontscheibe (10) für ein PV-Modul (5), wobei die Scheibe (10) einen Körper (15) aus einem transparenten Material mit einer Frontseite (11) und einer Rückseite (12) aufweist, wobei
- der transparente Körper (15) in seiner Frontseite (11) Aussparungen (20) hat, wobei diese Aussparungen durch Vorsprünge (30) des transparenten Körpers getrennt sind,
- die Aussparungen zumindest teilweise mit einem Farbstoff (4) gefüllt sind, wobei ein oberer Bereich (32) der Vorsprünge unbeschichtet bleibt und sich über den Farbstoff (4) erstreckt,
**dadurch gekennzeichnet, dass**
der Farbstoff einen niedrigeren Brechungsindex als das transparente Material hat.

9. Die Frontscheibe (10) nach Anspruch 8,
**dadurch gekennzeichnet, dass** die Aussparungen (20) eine Tiefe von 50 µm bis 750 µm aufweisen, wobei die Tiefe relativ zur mittleren Höhe der Vorsprünge (30) gemessen wird.

10. Die Frontscheibe (10) nach Anspruch 8 oder 9,
**dadurch gekennzeichnet, dass**
die mittlere maximale Dicke der Farbstoffschicht (4) in den Aussparungen (20) zwischen 1/10 und 9/10 der mittleren Höhe der Vorsprünge (30) relativ zu den Böden der Aussparungen (20) ist.

11. Die Frontscheibe (10) nach einem der Ansprüche 8 bis 10,
**dadurch gekennzeichnet, dass**
eine durchlässige Deckschicht die Vorsprünge und den Farbstoff bedeckt, wobei die durchlässige Deckschicht einen niedrigeren Brechungsindex als der Farbstoff (4) hat.

12. Ein PV-Modul (5) aufweisend eine Frontscheibe (10) mit einer Frontfläche (11) und einer Rückfläche (12), einem rückwärtigen Substrat (60) und mindestens einer Photodiode (70) zwischen der Rückfläche (12) der Frontscheibe (10) und dem rückwärtigen Substrat (60),
**dadurch gekennzeichnet, dass**
die Frontscheibe (10) eine Frontscheibe (10) nach einem der Ansprüche 8 bis 11 ist.

## Revendications

1. Procédé de fabrication d'un panneau avant (10) pour un module PV (5), comprenant au moins les étapes consistant à :
(i) fournir un panneau transparent (10) d'un matériau transparent, le panneau ayant au moins un côté avant (11), dans lequel le côté avant (11) comprend des évidements (20) avec des protubérances (30) entre eux, dans lequel chaque évidement a un fond (23)
(ii) remplir au moins partiellement les évidements (20) d'une couche de colorant (4), dans lequel une région supérieure (32) des protubérances demeure non revêtue et s'étend au-dessus du colorant (4),
**caractérisé en ce que** le colorant a un indice de réfraction inférieur à celui du matériau transparent.

2. Procédé selon la revendication 1, **caractérisé en ce que**
l'étape (i) comprend le sablage d'un côté avant (11) du panneau et/ou l'ablation au laser pour ainsi former des évidements (20) avec les protubérances (30) entre eux.

3. Procédé selon l'une des revendications 1 ou 2, **caractérisé en ce que**
l'étape (i) comprend la gravure de la surface avant (11) d'un panneau (10) pour ainsi former les évidements (20) avec des protubérances (30) entre eux.

4. Procédé selon l'une des revendications 1 à 3, **caractérisé en ce que**
l'étape (ii) comprend : le dépôt du colorant (4) sur la surface avant (11) du panneau et par la suite, le retrait du colorant des régions supérieures des protubérances (30) pour ainsi obtenir des évidements (20) entre les protubérances (30) qui sont partiellement remplis du colorant.

5. Procédé selon la revendication 4, **caractérisé en ce que**
le colorant est durci après retrait du colorant des régions supérieures des protubérances (30).

6. Procédé selon la revendication 5, **caractérisé en ce que** ledit durcissement comprend le chauffage de la surface avant (11) du panneau (10) pour ainsi faire fondre la portion supérieure (32) des protubérances (30).

7. Procédé selon l'une des revendications 1 à 6, **caractérisé en ce que**
un filtre antiparasite est déposé après achèvement de l'étape (ii) et/ou sur un côté arrière (12) du panneau avant (10), lequel côté arrière (12) est orienté dans la direction opposée au côté avant (11).

8. Panneau avant (10) pour un module PV (5), dans lequel le panneau (10) comprend un corps (15) d'un matériau transparent avec un côté avant (11) et un côté arrière (12), dans lequel
- le corps transparent (15) a des évidements (20) dans son côté avant (11), lesdits évidements étant séparés par des protubérances (30) du corps transparent,
- les évidements sont au moins partiellement remplis d'un colorant (4), dans lequel une région supérieure (32) des protubérances demeure non revêtue et s'étend au-dessus du colorant (4),
**caractérisé en ce que**
le colorant a un indice de réfraction inférieur au matériau transparent.

9. Panneau avant (10) selon la revendication 8,
**caractérisé en ce que** les évidements (20) ont une profondeur de 50 µm à 750 µm,
dans lequel la profondeur est mesurée par rapport à la hauteur moyenne des protubérances (30).

10. Panneau avant (10) selon la revendication 8 ou 9,
**caractérisé en ce que**,
l'épaisseur maximale moyenne de la couche de colorant (4) dans les évidements (20) est entre 1/10 et 9/10 de la hauteur moyenne des protubérances (30) par rapport aux fonds des évidements (20).

11. Panneau avant (10) selon l'une des revendications 8 à 10,
**caractérisé en ce que**
une couche de couverture transmissive couvre les protubérances et le colorant, dans lequel la couche de couverture transmissive a un indice de réfraction inférieur au colorant (4).

12. Module PV (5) comprenant un panneau avant (10) avec une surface avant (11) et une surface arrière (12), un substrat arrière (60) et au moins une photodiode (70) entre la surface arrière (12) du panneau avant (10) et le substrat arrière (60), **caractérisé en ce que**
le panneau avant (10) est un panneau avant (10) selon l'une des revendications 8 à 11.
